Europäisches Patentamt

European Patent Office

Office européen des brevets

(19)

(11) Numéro de publication : **0 082 035**
**B1**

(12) **FASCICULE DE BREVET EUROPÉEN**

(45) Date de publication du fascicule du brevet :
18.09.85

(51) Int. Cl.⁴ : **H 04 N 3/15, H 04 N 5/33, H 01 L 27/14**

(21) Numéro de dépôt : **82402114.1**

(22) Date de dépôt : **19.11.82**

(54) **Dispositif d'enregistrement et de lecture d'images.**

(30) Priorité : 07.12.81 FR 8122837

(43) Date de publication de la demande :
22.06.83 Bulletin 83/25

(45) Mention de la délivrance du brevet :
18.09.85 Bulletin 85/38

(84) Etats contractants désignés :
AT BE CH DE GB IT LI LU NL SE

(56) Documents cités :
WO-A-81 /020 84
FR-A- 2 299 775
IEEE JOURNAL OF SOLID-STATE CIRCUITS, vol. SC-11, no. 1, février 1976, pages 128-132, New York, USA D.M. BROWN et al.: "Transparent metal oxide electrode CID imager"
IEEE TRANSACTIONS ON ELECTRON DEVICES, vol. ED-25, no. 2, février 1978, pages 232-241, New York, USA J.C. KIM: "InSb charge-injection device imaging array"

(73) Titulaire : SOCIETE ANONYME DE TELECOMMUNI-CATIONS
40 avenue de New York
F-75116 Paris (FR)

(72) Inventeur : Sirieix, Michel Benoît
"Les Muses" 11 Parc de Diane
F-78350 Jouy en Josas (FR)

(74) Mandataire : Flechner, Willy et al
CABINET FLECHNER 22, Avenue de Friedland
F-75008 Paris (FR)

EP 0 082 035 B1

## Description

La présente invention concerne des dispositifs d'enregistrement et de lecture d'images et, plus particulièrement, des dispositifs de ce type utilisables dans le domaine de l'infrarouge.

Parmi les dispositifs d'enregistrement et de lecture d'images en rayonnement infrarouge, il est connu d'utiliser des dispositifs à l'état solide constitués principalement d'un substrat semi-conducteur, du type N par exemple, recouvert sur un côté d'une couche isolante mince, et sur le côté opposé d'une couche métallique conductrice. Des électrodes métalliques transparentes sont disposées régulièrement sur la couche isolante, par exemple sous la forme d'une matrice de rangées et de colonnes et constituant avec la couche isolante et le matériau semi-conducteur sous-jacent autant de cellules ou senseurs élémentaires d'un rayonnement infrarouge qui serait dirigé à l'aide d'un dispositif optique convenable sur lesdites électrodes. Chacune de ces électrodes ainsi que la couche métallique du substrat comportent un contact ohmique qui permet de leur appliquer des tensions électriques. En choisissant des tensions électriques convenables, il est possible de créer dans le semi-conducteur, sous l'isolant de chacune des électrodes transparentes, une zone de très faible épaisseur dans laquelle les porteurs libres sont moins nombreux que dans le reste du semi-conducteur. Cette zone « dépeuplée » peut alors recevoir des charges générées par suite de l'absorption de photons reçus à travers les électrodes transparentes. La quantité de charges ainsi accumulées est alors en relation directe avec la quantité de rayonnement reçue à travers l'électrode. La modification des tensions électriques appliquées aux contacts des électrodes transparentes et de la couche métallique du substrat permet de supprimer les zones dépeuplées en donnant naissance à un courant de décharge qui circule entre l'électrode et la couche métallique du substrat. La mesure de ce courant permet de déterminer la quantité de charges accumulées et donc la quantité de rayonnement infrarouge reçue.

Dans les dispositifs à l'état solide du type décrit ci-dessus, chaque électrode transparente, qui correspond à un senseur élémentaire ou une cellule élémentaire, a des dimensions de l'ordre de 50 microns et il faut donc grouper et assembler de nombreuses cellules élémentaires pour obtenir un écran et une image de dimensions convenables. Cependant, le nombre de cellules que l'on peut grouper et assembler, par exemple sous la forme d'une matrice de rangées et colonnes, est limité.

En effet, avec un écran de 1 024 cellules constitué par une matrice 32 × 32 au pas de 50 microns, le temps d'enregistrement serait d'une milliseconde, dans le cas d'un rayonnement infrarouge, ce qui signifierait un temps de lecture d'une microseconde environ par cellule, ce qui est actuellement impossible à réaliser.

Il a donc été proposé de grouper les cellules pour les opérations de lecture et de lire séquentiellement chaque groupe de cellules. C'est ainsi que dans une matrice 32 × 32, les 32 cellules d'une rangée sont lues simultanément en leur appliquant un signal électrique par l'intermédiaire d'un conducteur de rangée connecté à toutes les cellules d'une rangée ; les signaux lus apparaissent sur les 32 conducteurs de colonne, chaque conducteur de colonne étant connecté à une cellule d'une colonne. Cette organisation est satisfaisante lorsque le nombre de cellules connectées à un même conducteur de colonne est compris entre 32 et 64. En effet, d'une part, chaque conducteur de colonne a une de ses extrémités qui est connectée à un amplificateur dont la bande passante, et donc le bruit, sera d'autant plus grande que la fréquence des signaux lus sera grande, fréquence qui sera d'autant plus grande que le nombre de cellules d'une colonne sera élevé. D'autre part, le signal de chaque cellule élémentaire d'une colonne qui sera appliqué à l'amplificateur sera d'autant plus faible que le nombre de cellules d'une colonne sera élevé par suite de l'affaiblissement dû aux capacités des cellules de la colonne non sélectionnée pour la lecture. Ces deux phénomènes agissent en sens contraire en fonction du nombre de cellules d'une colonne déterminant un nombre de cellules au-dessus duquel le signal lu est inférieur au bruit de l'amplificateur et ne peut donc être détecté. Actuellement, ce nombre est compris entre 32 et 64 selon les matrices obtenues et les caractéristiques des amplificateurs.

Cette organisation matricielle par groupement des cellules d'une rangée présente également une limitation du nombre de cellules d'une rangée due à la constante de temps répartie des cellules élémentaires qui limite le temps d'accès à une cellule mais cette limitation est moindre que celle due au nombre de cellules d'une colonne.

Les limitations ci-dessus mentionnées ne permettent pas de réaliser des dispositifs d'enregistrement et de lecture d'images dans le spectre infrarouge qui donneraient des images au format télévision, par exemple 625 lignes, ceci de manière à pouvoir transférer l'image infrarouge sur un écran de télévision par un balayage lignes. En effet, pour un tel transfert, le dispositif d'enregistrement et de lecture d'images dans le spectre infrarouge devrait comporter 625 cellules élémentaires par colonne alors que la limitation mentionnée ci-dessus est comprise entre 32 et 64.

Le but de la présente invention est donc de réaliser des dispositifs d'enregistrement et de lecture d'images dans le spectre infrarouge qui permettent d'obtenir des images type format télévision.

L'objet de la présente invention est donc un dispositif d'enregistrement et de lecture d'images dans le domaine infrarouge qui comprend un substrat en matériau semi-conducteur présentant deux faces principales opposées parallèles, une couche conductrice recouvrant une des deux faces principales opposées, une première couche isolante recouvrant toute la surface de l'autre face principale, une première pluralité d'électrodes en matériau conducteur transparent et disposées régulièrement suivant des colonnes, une deuxième couche isolante recouvrant la première pluralité d'électrodes en matériau conducteur transparent disposées régulièrement suivant des rangées et une troisième couche isolante recouvrant les électrodes conductrices transparentes de la deuxième pluralité. Selon l'invention, chaque électrode de la première pluralité est de forme rectangulaire et est entourée de manière précise par une électrode de la deuxième pluralité qui a la forme d'un pourtour rectangulaire de manière à constituer une cellule élémentaire d'enregistrement et de lecture. En outre, les électrodes périphériques de chaque rangée de la deuxième pluralité sont connectées entre elles et à un circuit d'adressage par un premier conducteur de liaison tandis que les électrodes centrales de chaque colonne sont connectées entre elles et à un amplificateur par un deuxième conducteur de liaison.

Afin d'augmenter encore le nombre de cellules élémentaires qui peuvent être groupés sur un même substrat sans pour autant augmenter le nombre de cellules connectées à un conducteur de liaison relié à un amplificateur, il est proposé d'arranger les cellules élémentaires en quinconce et de prévoir des moyens pour empêcher les perturbations dues aux courants circulant dans les conducteurs de liaison, lesdits moyens pouvant comprendre des électrodes conductrices de garde sous-jacentes auxdits conducteurs de liaison ou des zones d'isolation diffusées dans le substrat semi-conducteur et sous-jacentes auxdits conducteurs de liaison.

On peut encore augmenter le nombre de cellules élémentaires en scindant électriquement en deux chaque électrode de la pluralité qui est connectée au registre d'adressage.

La présente invention sera mieux comprise à la lecture de la description suivante d'exemples particuliers de réalisation en relation avec les dessins dans lesquels :

la figure 1 est un schéma très simplifié et agrandi d'un dispositif d'enregistrement et de lecture d'images dans le spectre infrarouge ;

la figure 2 est une vue agrandie, partie en coupe selon l'axe 2-2 de la figure 1, partie en perspective, de la cellule C11 du dispositif de la figure 1 ;

les figures 3a à 3i sont des diagrammes de signaux d'adressage et de lecture du dispositif de la figure 1 ;

la figure 4 est un dispositif d'enregistrement et de lecture d'images dans le spectre infrarouge résultant du groupement sur un même support de quatre dispositifs analogues à celui décrit en relation avec la figure 1 ;

la figure 5 est un dispositif d'enregistrement de lecture d'images dans le spectre infrarouge résultant du groupement sur un même substrat de quatre dispositifs analogues à celui décrit en relation avec la figure 1 ;

la figure 6 est une vue schématique agrandie, partie en coupe, partie en perspective, d'une partie d'une matrice de cellules élémentaires arrangées en quinconce ;

la figure 7 est une vue schématique agrandie, partie en coupe, partie en perspective, d'une partie d'une matrice de cellules élémentaires arrangées en quinconce, chaque cellule élémentaire comportant deux demi-cellules :

la figure 8 est un schéma très simplifié et agrandi d'un dispositif d'enregistrement et de lecture présentant les caractéristiques du dispositif décrit en relation avec la figure 7 ;

les figures 9a à 9e sont des diagrammes de signaux d'adressage et de lecture de la matrice de cellules élémentaires décrite en relation avec les figures 7 et 8.

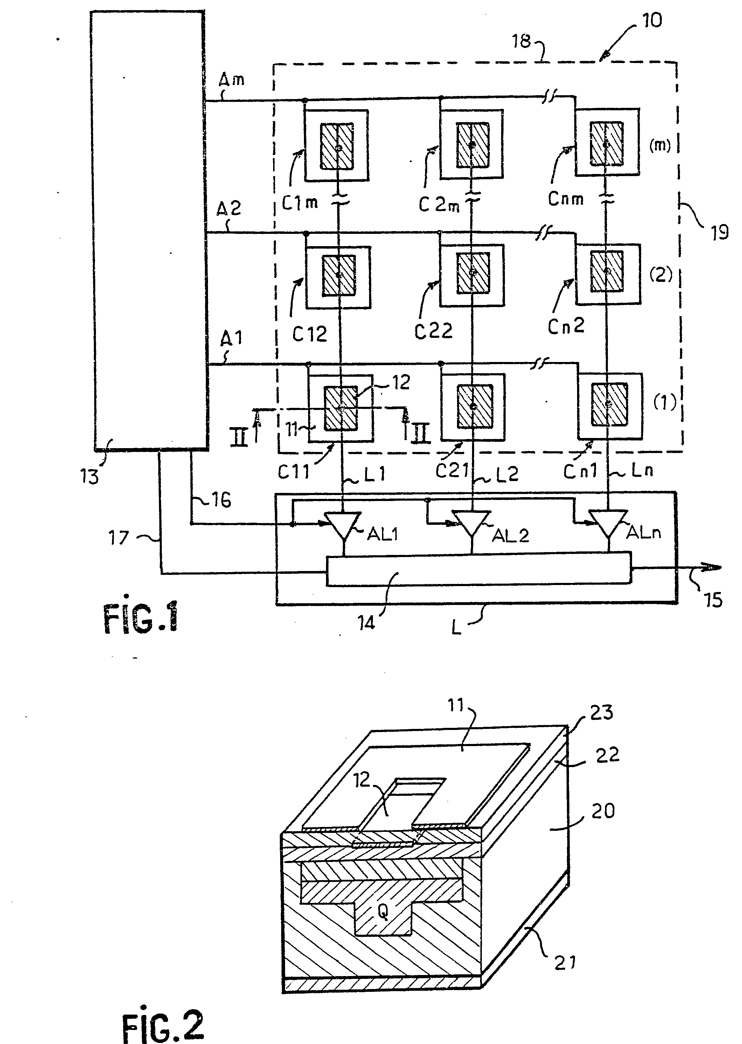

La figure 1 est une représentation électrique schématique très simplifiée et agrandie d'un dispositif d'enregistrement et de lecture d'images dans le domaine infrarouge montrant une matrice 10 comportant m rangées numérotées de 1 à m et n colonnes numérotées de 1 à n de manière à définir m x n cellules élémentaires. Sur la figure, seules neuf cellules ont été représentées et portent les références C11, C12, C1m, C21, C22, C2m, Cn1, Cn2 etCnm. Comme on le décrira en relation avec la figure 2, chaque cellule comporte une électrode d'adressage telle que celle référencée 11 et une électrode de lecture telle que celle référencée 12. Les n électrodes d'adressage d'une rangée sont connectées à un conducteur d'adressage référencé A1 pour la rangée 1, A2 pour la rangée 2 et Am pour la rangée m, les m conducteurs d'adressage constituant les conducteurs de sortie d'un registre d'adressage 13. Les m électrodes de lecture d'une colonne sont connectées à un conducteur de lecture référencé L1 pour la colonne 1, L2 pour la colonne 2 et Ln pour la colonne n et chaque conducteur de lecture est connecté à l'entrée d'un amplificateur de lecture référencé AL1 pour la colonne 1, AL2 pour la colonne 2 et ALn pour la colonne n. Les sorties des n amplificateurs AL1 à ALn sont connectées à un circuit de multiplexage 14 dont le signal de sortie apparaît sur le conducteur 15. Il est à noter que chaque amplificateur AL1 à ALn comporte à son entrée un circuit d'échantillonnage, du type « échantillonneur-bloqueur » par exemple, qui échantillonne le signal lu sur la cellule de la colonne qui a été adressée. Afin de réaliser cette opération d'échantillonnage ainsi que l'opération de multiplexage mentionnée ci-dessus, les amplificateurs et le circuit de multiplexage reçoivent des signaux en provenance du registre d'adressage 13 par l'intermédiaire de liaisons électriques référencées 16 pour l'échantillonnage et 17 pour le multiplexage.

La figure 2 est une vue partielle, partie en coupe et partie en perspective, de la cellule C11 de la matrice 10, la coupe ayant été faite selon la ligne 2-2. La matrice 10 se présente sous la forme d'une plaquette constituée d'un substrat semi-conducteur 20, du type N par exemple. Sur la figure 2, on n'a représenté que le volume de substrat semi-conducteur se trouvant sous les électrodes de la cellule élémentaire C11. La surface inférieure du substrat semi-conducteur 20 est recouverte d'une couche métallique conductrice 21, en or par exemple, qui sert d'électrode de référence pour les tensions qui sont appliquées aux autres électrodes qui seront décrites ci-après. La surface supérieure du semi-conducteur 20 est entièrement recouverte d'une première couche d'isolant 22, par exemple de la silice. L'électrode de lecture 12 est en métal, en Nickel-chrome par exemple, et est déposée sous la forme d'une couche mince transparente. Cette électrode de lecture est connectée au conducteur de lecture L1, en Chrome-or par exemple, qui est déposé sur la mince couche isolante 22. Cette électrode 12 ainsi que la couche isolante 22 sont recouvertes d'une deuxième couche isolante 23, en silice par exemple, de manière à pouvoir déposer autour de l'électrode de lecture 12, mais sans contact avec elle, l'électrode d'adressage 11 qui est une couche métallique mince transparente en Nickel-Chrome par exemple. L'électrode d'adressage est connectée au conducteur d'adressage A1, en Chrome-or par exemple, qui est déposé sur la couche isolante 23. L'ensemble constitué par l'électrode d'adressage 11, le conducteur d'adressage A1 et la couche isolante sous-jacente 23 est recouvert d'une troisième couche isolante, en silice par exemple, non représentée sur la figure 2.

A titre indicatif, les épaisseurs des différents éléments décrits ci-dessus sont les suivantes :

500 microns à 1 000 microns pour le substrat ;

300 Angströms à 1 000 Angströms pour la couche métallique 21 ;

700 Angströms à 1 500 Angströms pour les différentes couches isolantes ;

100 Angströms à 300 Angströms pour l'électrode d'adressage et l'électrode de lecture ;

300 Angströms à 500 Angströms pour les conducteurs.

Egalement à titre indicatif, les dimensions des électrodes et des conducteurs sont les suivantes :

20 microns de côté pour une électrode de lecture en forme de carré ;

40 microns de côté extérieur pour une électrode d'adressage ;

5 microns pour les conducteurs.

Les dimensions des électrodes indiquées ci-dessus peuvent varier en fonction de leur position respective par rapport au substrat sachant que la surface de l'électrode est d'autant plus petite qu'elle est proche du substrat. C'est ainsi que la surface de l'électrode d'adressage qui, dans l'exemple décrit, est trois fois supérieure à celle de l'électrode de lecture, pourrait être égale ou même inférieure à celle de l'électrode de lecture si elle était disposée soit au même niveau que l'électrode de lecture ou à niveau inférieur.

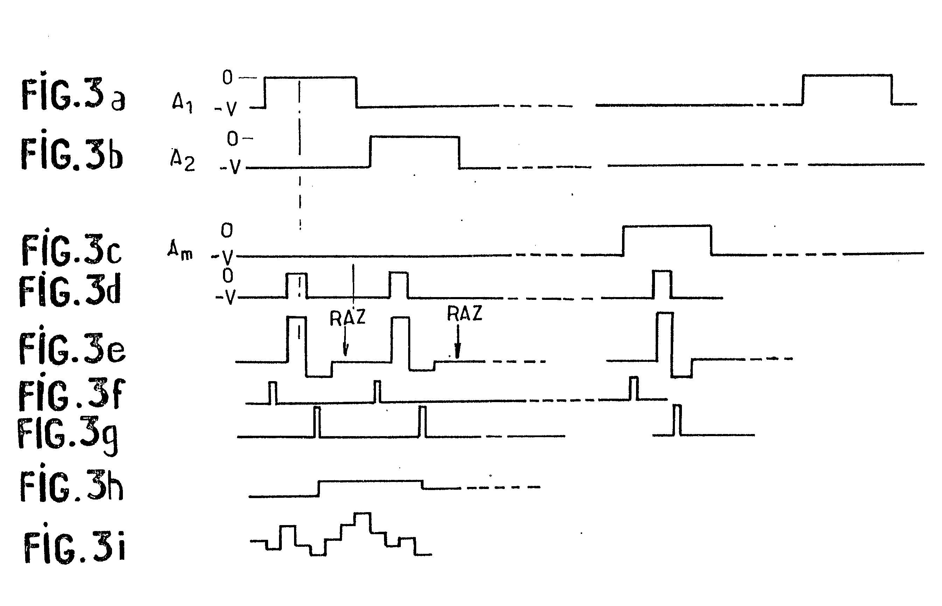

Les figures 3a à 3i sont des diagrammes de signaux à différents points du dispositif d'enregistrement et de lecture de la figure 1. Ainsi les figures 3a à 3c sont les diagrammes des signaux d'adressage appliqués aux électrodes d'adressage des rangées A1, A2 et Am. La figure 3d est le diagramme des signaux qui sont appliqués à une colonne, par exemple la colonne L1. La figure 3e est le diagramme des signaux qui apparaissent à l'entrée de l'amplificateur AL1 avant l'échantillonnage. Les figures 3f et 3g sont les diagrammes des signaux de commande de l'échantillonneur-bloqueur disposé à l'entrée de l'amplificateur AL1. La figure 3h est le diagramme des signaux qui apparaissent à la sortie de l'échantillonneur-bloqueur avant amplification. Enfin, la figure 3i est le diagramme des signaux qui apparaissent sur le conducteur de sortie 15 du circuit de multiplexage 14, la partie du signal pendant la durée de l'impulsion du signal de la figure 3a correspondant aux signaux lus sur les différentes cellules de la rangée A1. On comprend que ce procédé de lecture permet de lire séquentiellement les différentes cellules d'une rangée, A1 par exemple, puis de lire ensuite les cellules correspondantes de la rangée suivante, A2 par exemple, et ainsi de suite, c'est-à-dire une lecture rangée par rangée, ou ligne par ligne, analogue à une lecture par trame d'un écran de télévision.

Comme cela a été mentionné ci-dessus, certains phénomènes conduisent à limiter le nombre m de cellules élémentaires qui peuvent être connectées à un même conducteur de lecture et actuellement le nombre m ne peut dépasser 64. Pour les cellules élémentaires connectées à un même conducteur d'adressage, cette limitation est moindre et le nombre n peut atteindre et dépasser 100.

Avec de telles limitations, on ne peut obtenir que des dispositifs comportant 64 rangées et 100 colonnes, alors que pour obtenir un format télévision il faudrait un minimum de 256 rangées et 400 colonnes.

Aussi pour aboutir à ce format d'image, ou du moins à un format voisin, il est proposé de grouper les cellules élémentaires ou les matrices de cellules élémentaires de différentes manières.

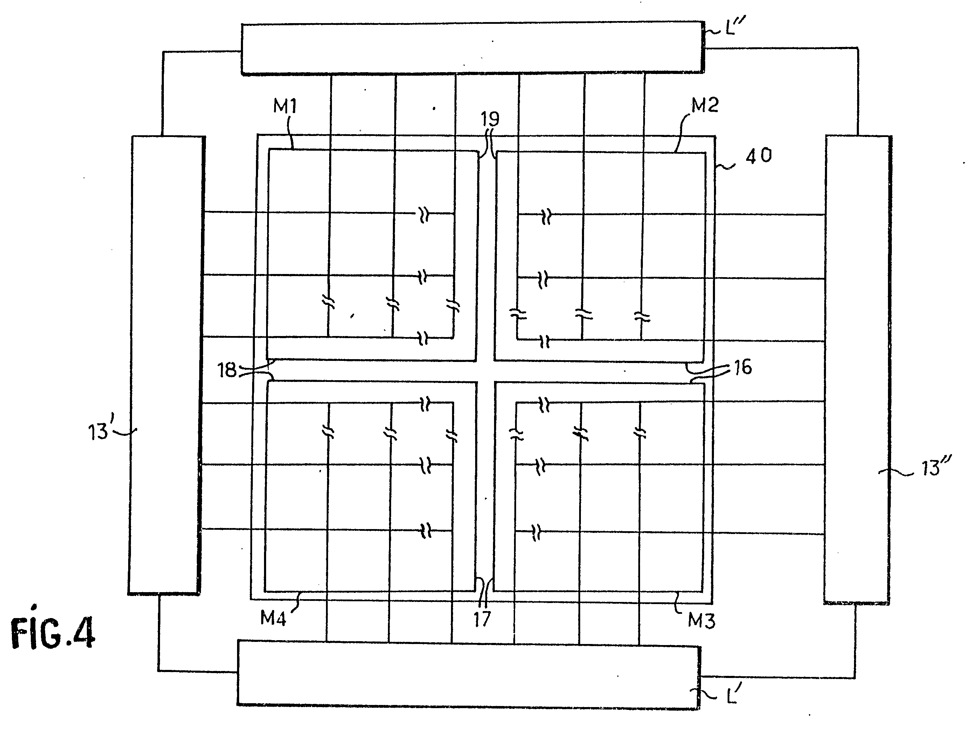

Ainsi sur la figure 4, quatre matrices élémentaires, dont chacune est analogue à la matrice 10 de la figure 1, sont groupées, selon la présente invention, sur un même support 40, de manière que les côtés 18 et 19 d'une matrice élémentaire, M1 par exemple, soient en regard, respectivement, des côtés analogues 18 et 19 dans deux matrices adjacentes M4 et M2.

Les conducteurs de rangée des matrices M1 et M4 sont connectés à un circuit d'adressage 13' tandis que les conducteurs de rangées des matrices M2 et M3 sont connectés à un circuit d'adressage 13'', les registres 13' et 13'' étant analogues au circuit d'adressage 13 de la figure 1. Les conducteurs de colonne, c'est-à-dire de lecture, des matrices M1 et M2 sont connectés à un circuit de lecture L'' tandis que les conducteurs de lecture des matrices M3 et M4 sont connectés à un circuit de lecture L'' tandis que les conducteurs de lecture des matrices M3 et M4 sont connectées à un circuit de lecture L' les circuits de lecture étant analogues au circuit de lecture L de la figure 1 et comprenant chacun un circuit d'échantillonnage et d'amplification par colonne et un circuit de multiplexage, lesdits circuits étant commandés par des signaux en provenance des circuits d'adressage 13' et 13".

Avec un tel arrangement, on peut obtenir, à titre d'exemple, une matrice de 128 rangées et 200 colonnes.

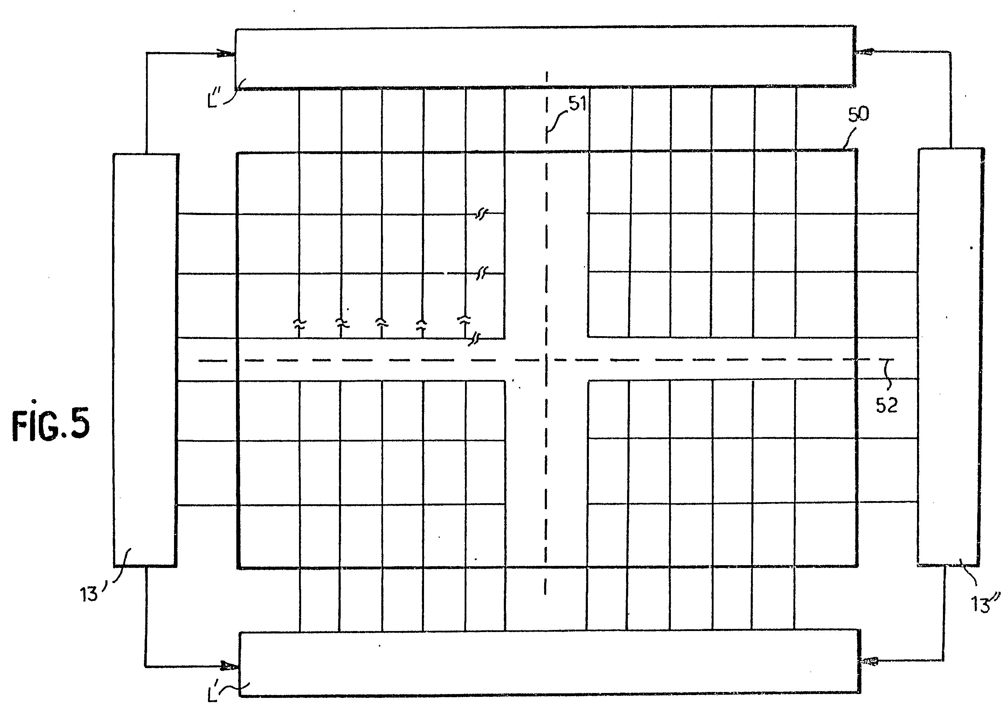

Au lieu d'utiliser quatre matrices élémentaires comme le montre la figure 4, c'est-à-dire quatre matrices obtenues chacune à partir d'un substrat, il est proposé, selon la figure 5, de les obtenir à partir d'un substrat unique 50 et de couper les connexions des rangées et des colonnes selon les axes de symétrie 51 et 52, respectivement. Comme dans l'exemple décrit en relation avec la figure 4, les conducteurs de rangée d'un côté de l'axe 51 sont connectés au circuit d'adressage 13' tandis que les conducteurs de rangée de l'autre côté de l'axe 51 sont connectés au circuit d'adressage 13". De même, les conducteurs de colonne d'un côté de l'axe 52 sont connectés au circuit de lecture L tandis que les conducteurs de colonne de l'autre côté de l'axe 52 sont connectés au circuit de lecture L".

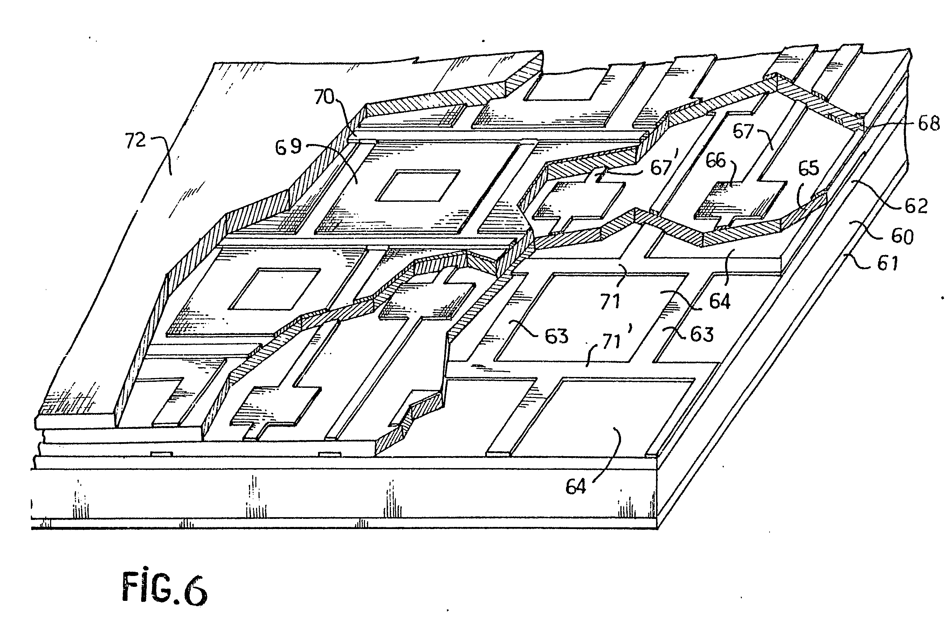

La figure 6 représente une autre forme de groupement de cellules élémentaires selon l'invention. Pour permettre une meilleure compréhension de la disposition des cellules et des conducteurs et de la manière de les obtenir, la figure 6 est une vue, partie en coupe, partie en coupe, partie en perspective, d'une partie de matrice. Cette figure fait apparaître que les différentes cellules élémentaires ne sont pas alignées suivant des rangées et des colonnes mais sont arrangées en quinconce, cet arrangement permettant de doubler le nombre de rangées sans augmenter le nombre de cellules connectées à un amplificateur de lecture. Pour qu'une telle matrice puisse fonctionner, il faut prévoir des moyens pour que les signaux d'adressage et de lecture des cellules disposées suivant des rangées et des colonnes ne perturbent pas les charges des autres cellules disposées en quinconce par rapport aux premières. A cet effet, selon une caractéristique de la présente invention, la matrice comporte des électrodes de garde, disposées sous les conducteurs d'adressage et de lecture.

Sur la figure 6, la matrice comprend un substrat semi-conducteur 60 de type N obtenu à partir d'antimoniure d'indium ou de tellurure de mercure-cadmium. Une couche métallique 61 est déposée sur une des faces tandis qu'une première couche isolante 62 est déposée sur l'autre face. Des électrodes de garde opaques 63 sont déposées sur la couche isolante 62 et ont la forme indiquée sur la figure. Ces électrodes définissent des surfaces internes en forme de rectangles (ou carrés) 64 qui correspondent à des cellules élémentaires disposées en quinconce. Une deuxième couche isolante 65 recouvre les électrodes de garde 63 et les rectangles (ou carrés) 64. Des électrodes de lecture transparentes 66 et des conducteurs de lecture transparentes 66 et des conducteurs de lecture opaques 67 ayant la forme montrée sur la figure sont déposés sur la deuxième couche isolante 65. Les électrodes de lecture 66, en forme de rectangles (ou carrés) sont disposées au centre des rectangles (ou carrés) 64. On remarquera que les conducteurs de lecture 67 d'une colonne de cellules coïncident avec les électrodes de garde adjacentes d'un côté à une colonne de cellules en quinconce. C'est ainsi que les électrodes de lecture 67 et 67' coïncident respectivement avec les électrodes de garde 63 et 63'.

Une troisième couche isolante 68 recouvre les électrodes de lecture 66, les conducteurs de lecture 67 et la partie de la deuxième couche isolante 65 non recouverte par les électrodes de lecture et les conducteurs de lecture. Des électrodes d'adressage transparentes 69 et des conducteurs d'adressage opaques 70 sont disposés sur la troisième couche isolante 68 selon le dessin montré sur la figure. Chaque électrode d'adressage d'une cellule entoure l'électrode de lecture de la même cellule et son périmètre coïncide au périmètre des rectangles (ou carrés) 64. Les électrodes d'adressage d'une rangée de cellules sont connectées entre elles par un conducteur d'adressage opaque tel que celui référencé 70 et les conducteurs d'adressage coïncident avec les branches des électrodes de garde sous-jacentes telles que celles référencées 71 et 71'. Une quatrième couche isolante 72 recouvre l'ensemble des électrodes d'adressage des conducteurs d'adressage et les espaces intermédiaires.

Les matériaux, épaisseurs et dimensions des différents éléments décrits ci-dessus en relation avec la figure 6 sont semblables à ceux décrits en relation avec l'exemple de réalisation de la figure 1. Cependant, en ce qui concerne les électrodes de garde, elles sont en chrome-or, ont une épaisseur de 300 à 500 Angströms et une largeur de 10 microns environ.

Avec un tel arrangement en quinconce des cellules élémentaires, on peut obtenir, eu égard aux limitations signalées ci-dessus, des matrices de 128 rangées et 200 colonnes par exemple. Dans une telle réalisation, les 64 conducteurs de rangée de rang impair seront par exemple connectés à un premier circuit d'adressage tandis que les 100 conducteurs de colonne de rang impair correspondants seront par exemple connectés à un premier circuit de lecture ; alors, les 64 conducteurs de rangée de rang pair seront connectés à un deuxième circuit d'adressage tandis que les 100 conducteurs de colonne de rang pair correspondants seront connectés à un deuxième circuit de lecture. De cette manière, on pourra lire d'abord les rangées de rang impair, c'est-à-dire une demi-matrice, puis les rangées de rang pair, c'est-à-dire l'autre demi-matrice, comme lors d'un balayage d'écran de télévision.

On comprend facilement que les premier et deuxième circuits d'adressage peuvent être réunis en un seul circuit d'adressage comportant 128 sorties tandis que les premier et deuxième circuits de lecture peuvent être réunis en un seul circuit de lecture comportant 200 amplificateurs de lecture.

On comprend également que cette lecture alternée des rangées de rang impair puis des rangées de rang pair peut être remplacée par une lecture séquentielle des rangées comme cela a été décrit en relation avec l'exemple particulier de réalisation décrit en relation avec les figures 1, 2 et 3.

Enfin, comme on l'a décrit en relation avec les figures 4 et 5, on peut grouper quatre matrices du type de celle décrite en relation avec la figure 6, de manière à obtenir une matrice de 256 rangées et 400 colonnes, c'est-à-dire une matrice d'un format type de télévision.

Les diagrammes des signaux d'adressage et de lecture d'une demi-matrice de la figure 6 sont semblables à ceux décrits en relation avec la figure 3 et ne seront pas décrits plus en détail ici.

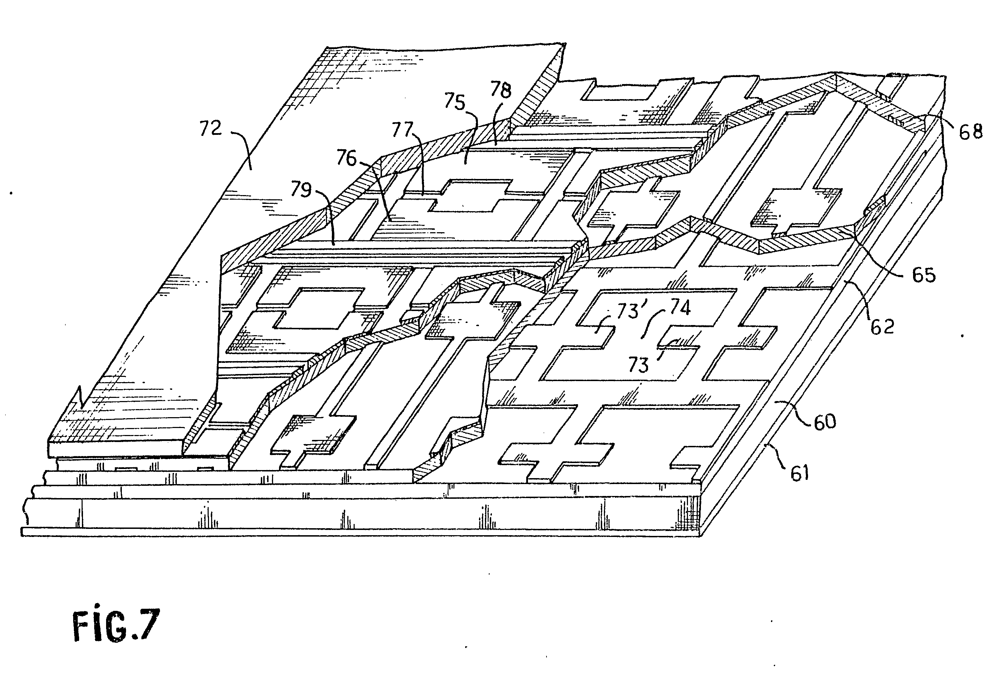

La figure 7 illustre une autre forme de réalisation selon la présente invention d'une matrice semblable à celle illustrée sur la figure 6 mais dans laquelle chaque cellule élémentaire est divisée en deux demi-cellules qui comportent une même électrode de lecture mais deux électrodes d'adressage connectées chacune à un conducteur d'adressage. Pour tenir compte de cette nouvelle structure des électrodes d'adressage, les électrodes de garde coïncident non seulement avec les conducteurs de lecture et d'adressage mais aussi avec l'espace séparant les électrodes d'adressage d'une même cellule.

Sur la figure 7, les éléments identiques à ceux de la figure 6 portent les mêmes références, les seuls éléments différents étant les branches 63 et 63' des électrodes de garde, les électrodes d'adressage 69 et les conducteurs d'adressage 70. Ainsi, les branches 63 et 63' des électrodes de garde prennent la forme de croix 73 et 73', l'espace 74 entre les bras voisins de deux croix d'une même rangée de cellules étant réservé à l'électrode de lecture 66'. Chaque électrode d'adressage 69 est divisée en deux parties égales 75 et 76 séparées par un espace 77 de l'ordre de 5 microns. Les demi-électrodes d'adressage 75 d'une rangée sont connectées à un même conducteur d'adressage 78 qui sera de rang ; impair et les demi-électrodes d'adressage 76 sont connectées à un même conducteur d'adressage 79 qui sera de rang pair.

Les dimensions et les épaisseurs des différents éléments de la matrice de la figure 7 sont sensiblement les mêmes que celles de la matrice de la figure 6 à l'exception des branches 71 et 71' des électrodes de garde qui sont plus larges, de l'ordre de 10-15 microns, pour tenir compte du fait qu'ils coïncident avec deux conducteurs d'adressage adjacents de deux rangées adjacentes de cellules en quinconce. En ce qui concerne les branches 73 et 73' des électrodes de garde, elles ont une largeur de 10 microns environ.

Avec un tel arrangement, on peut, par exemple, connecter les conducteurs de rangée de rang impair à un premier circuit d'adressage et connecter les conducteurs de rangée de rang pair à un deuxième circuit d'adressage. Les conducteurs de colonne sont connectés à un circuit de lecture unique comportant autant d'amplificateurs que de colonnes.

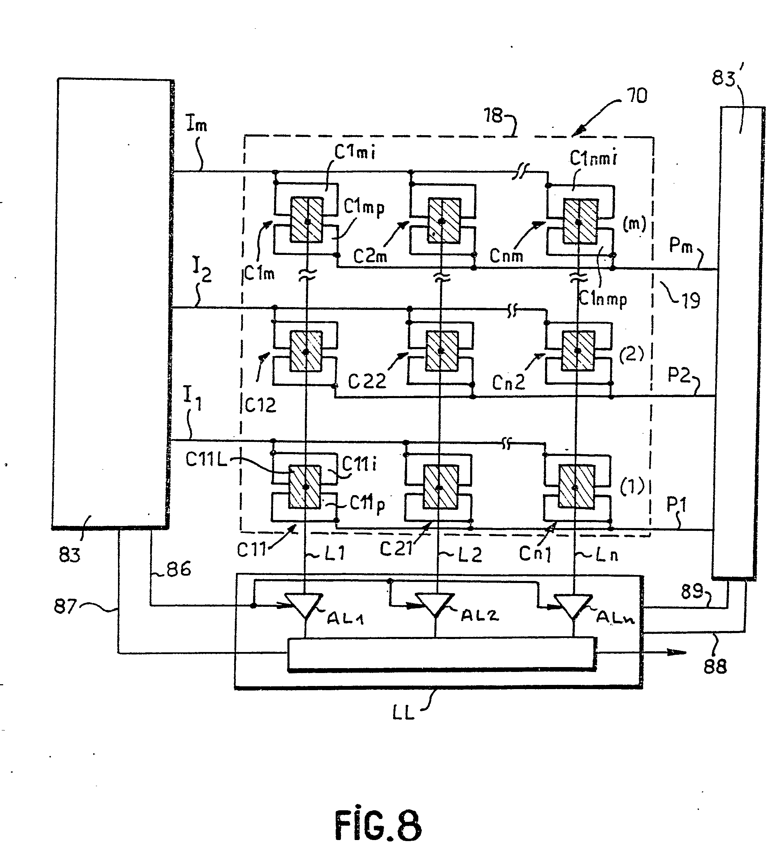

La figure 8 est un schéma analogue à celui de la figure 1, du dispositif décrit en relation avec la figure 7. Sur ce schéma, chaque cellule élémentaire, telle que C11, est scindée en deux demi-cellules qui comportent une même électrode de lecture, telle que C11L, et deux électrodes d'adressage, telles que C11i pour celle de rang impair et C11p pour celle de rang pair. Les électrodes d'adressage de rang impair sont connectées à un circuit d'adressage 83 par l'intermédiaire de conducteurs Il à Im tandis que les électrodes d'adressage de rang pair sont connectées à un circuit d'adressage 83' par l'intermédiaire de conducteurs Pl à Pm. Les circuits d'adressage 83 et 83' sont connectés à un circuit de lecture LL par l'intermédiaire de conducteurs 86, 87 et 88, 89, ledit circuit de lecture LL recevant les signaux de lecture des cellules par l'intermédiaire des conducteurs de lecture L1 à Ln. Sur le schéma de la figure 8, les autres éléments sont identiques à ceux du schéma de la figure 1.

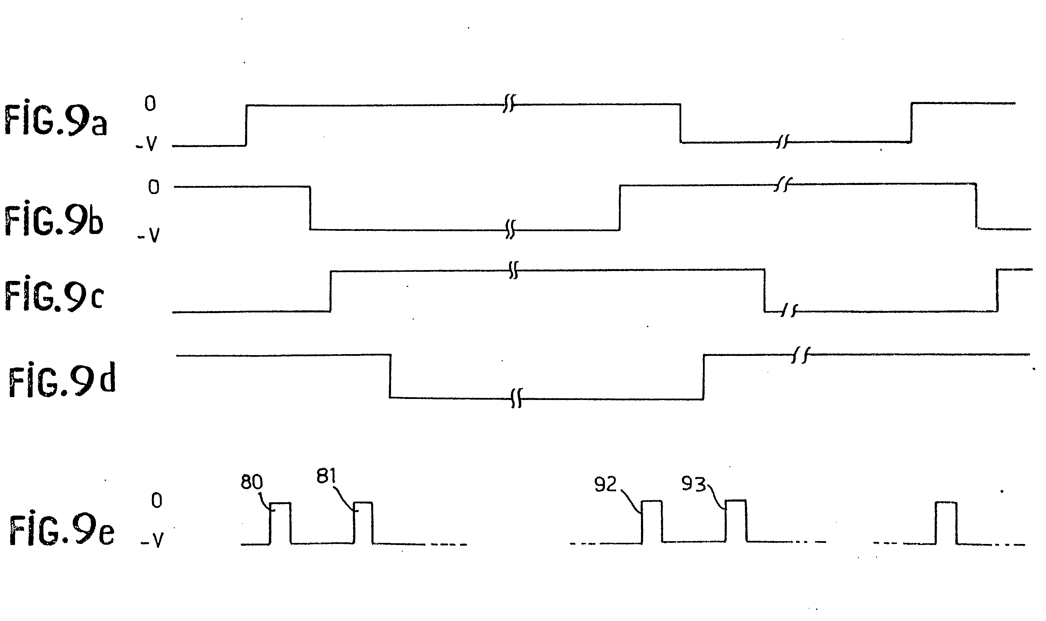

Les figures 9a à 9e sont les diagrammes de signaux qui sont appliqués à des conducteurs de rangée successifs de la matrice décrite en relation avec les figures 7 et 8, par exemple, les conducteurs I1, I2 et P1, P2 de la figure 8, tandis que la figure 9e est un diagramme de signaux qui sont appliqués aux conducteurs de colonne. Lorsque les signaux sont à un potentiel négatif -V, les cellules élémentaires localisées sous les électrodes intègrent le rayonnement infrarouge reçu sous la forme de quantités de charges électriques. Lorsque les signaux appliqués aux conducteurs de rangée passent au potentiel de la masse, les quantités de charge accumulées sont transférées dans les cellules élémentaires localisées sous les électrodes de lecture. Enfin, lorsque, ensuite, les signaux appliqués aux colonnes passent de -V au potentiel de la masse, les charges accumulées sous les électrodes de lecture sont écoulées sur les conducteurs de lecture, le signal 1u étant proportionnel au temps d'intégration, c'est-à-dire le temps pendant lequel les électrodes sont restées au potentiel -V. C'est ainsi que les demi-cellules de la rangée impaire I1 sont lues au moment de l'impulsion 80 de la figure 8e, que les demi-cellules de la rangée impaire I2 sont lues au moment de l'impulsion 81, que les demi-cellules de la rangée paire P1 sont lues au moment de l'impulsion 92 et que les demi-cellules de la rangée paire P2 sont lues au moment de l'impulsion 93.

L'arrangement décrit en relation avec les figures 7, 8 et 9 permet donc, sans augmenter la surface de la matrice, d'une part de doubler le nombre de sites élémentaires par division par 2 des cellules élémentaires et, d'autre part, de réaliser un balayage type télévision. On obtient ainsi une matrice de 256 rangées et 200 colonnes sur un même substrat.

Il est clair que les matrices décrites en relation avec les figures 6 à 9 peuvent être groupées selon les arrangements décrits en relation avec les figures 4 et 5, ce qui permet de doubler le nombre de rangées et de colonnes.

Les matrices qui viennent d'être décrites sont obtenues par le dépôt successif de couches isolantes qui recouvrent toute la surface du substrat et de couches conductrices qui n'en recouvrent qu'une partie, ce qui a pour conséquence de créer des surépaisseurs aux endroits de couches conductrices et d'obtenir des électrodes d'adressage et de lecture qui ne sont pas au même niveau comme cela a été signalé ci-dessus. On comprend que pour l'homme de l'art, il est possible de réaliser des matrices selon la présente invention en mettant en œuvre des procédés de fabrication connus de manière à obtenir par exemple des électrodes d'adressage et de lecture au même niveau.

Il a été décrit, en relation avec les figures 6 et 7, des matrices comportant des électrodes de garde ; on peut éviter d'avoir à recourir à des électrodes de garde si, par des procédés chimiques, on délimite dans le substrat semi-conducteur des cellules élémentaires.

## Revendications

1. Dispositif d'enregistrement et de lecture d'images dans le domaine infrarouge comportant un substrat (20) en matériau semi-conducteur de type N ou P présentant deux faces principales opposées parallèles, une couche conductrice (21) recouvrant une des deux faces principales opposées, une première couche isolante (22) recouvrant toute la surface de l'autre face principale, une première pluralité d'électrodes (12) en matériau conducteur transparent disposées régulièrement suivant des colonnes, une deuxième couche isolante (23) recouvrant la première pluralité d'électrodes conductrices transparentes (12), une deuxième pluralité d'électrodes (11) en matériau conducteur transparent disposées régulièrement suivant des rangées et une troisième couche isolante recouvrant les électrodes conductrices transparentes de la deuxième pluralité d'électrodes (11), caractérisé en ce que chaque électrode de la première pluralité (12) est de forme rectangulaire et est entourée de manière précise par une électrode de la deuxième pluralité (11) qui a la forme d'un pourtour rectangulaire de manière à constituer une cellule élémentaire d'enregistrement et de lecture, en ce que les électrodes périphériques de chaque rangée de la deuxième pluralité d'électrodes (11) sont connectées entre elles et à un circuit d'adressage (13 ou 83, 83') par un premier conducteur de liaison (A1 à Am ou I1 à Im et P1 à Pm) et en ce que les électrodes centrales de chaque colonne de la première pluralité d'électrodes (12) sont connectées entre elles et à un amplificateur (AL1, AL2 ... ALn) par un deuxième conducteur de liaison (L1, L2 ... Ln).

2. Dispositif selon la revendication 1, caractérisé en ce que les électrodes conductrices transparentes (66 et 69) sont disposées de manière que les cellules élémentaires d'enregistrement et de lecture soient disposées en quinconce et suivant des rangées et des colonnes et en ce que des moyens (63, 63', 71, 71') sont prévus pour que les courants circulant dans les conducteurs de liaison (67, 67', 70) ne perturbent pas le fonctionnement des cellules élémentaires.

3. Dispositif selon la revendication 1 ou la revendication 2, caractérisé en ce que chaque électrode (69) de la deuxième pluralité est constituée de deux demi-électrodes (75, 76) séparées électriquement, chaque demi-électrode (75 ou 76) étant connectée à un conducteur de liaison (78 ou 79) différent du conducteur de liaison connecté à l'autre demi-électrode.

4. Dispositif selon la revendication 3, caractérisé en ce que les moyens qui empêchent les perturbations dues aux courants circulant dans les conducteurs de liaison (67, 70, 78, 79) comprennent des électrodes de garde conductrices (63, 63', 71, 71', 73, 73') qui sont disposées sous-jacentes auxdits conducteurs de liaison.

5. Dispositif selon la revendication 4, caractérisé en ce que lesdites électrodes de garde (63, 63', 71, 71', 73, 73') sont disposées sur la première couche isolante (62) et sont séparées de la première pluralité d'électrodes conductrices transparentes (66) par une quatrième couche isolante (65).

6. Dispositif selon la revendication 4 ou 5, et suivant la disposition de la revendication 3, caractérisé en ce que les électrodes de garde (63, 63') comportent des branches (73, 73') qui sont sous-jacentes aux lignes de séparation (77) des demi-électrodes (75, 78).

7. Dispositif selon la revendication 2 ou la revendication 3, caractérisé en ce que les moyens qui empêchent les perturbations dues aux courants circulant dans les conducteurs de liaison sont constitués par des zones d'isolation diffusées dans le substrat semi-conducteur, et ayant des contours définis par les contours périphériques des électrodes conductrices transparentes de la deuxième pluralité.

8. Dispositif selon l'une quelconque des revendications précédentes, caractérisé en ce que la deuxième couche isolante (23 ou 68) ne recouvre que les bords des électrodes conductrices transparentes (12, 67) de la première pluralité.

## Claims

1. Image pick-up and read-out apparatus in the infra-red field, comprising a substrate (20) of semi-conductor material of the N or P type, having two parallel opposite main faces, a conductor layer (21) covering one of the two opposite main faces, a first insulating layer (22) covering the entire surface of the other main face, a first plurality of electrodes (12) of transparent conductor material disposed regularly in columns, a second insulating layer (23) covering the first plurality of transparent conductor electrodes (12), a second plurality of electrodes (11) of transparent conductor material disposed regularly in rows, and a third insulating layer covering the transparent conductor electrodes of the second plurality of electrodes (11), characterised in that each electrode of the first plurality (12) is of rectangular shape and is surrounded exactly by an electrode of the second plurality (11) which has the shape of a rectangular periphery, so as to constitute an elementary pick-up and read-out cell, in that the peripheral electrodes of each row of the second plurality of electrodes (11) are connected to each other and to an address circuit (13 or 83, 83') by a first joining conductor (A1 to Am or I1 to Im and P1 to Pm), and in that the central electrodes of each column of the first plurality of electrodes (12) are connected to each other and to an amplifier (AL1, AL2 ... ALn) by a second joining conductor (L1, L2 ... Ln).

2. Device according to claim 1, characterised in that the transparent conductor electrodes (66 and 69) are disposed in such a way that the elementary pick-up and read-out cells are arranged in a zig-zag and in rows and columns, and in that means (63, 63', 71, 71') are provided so that the currents circulating in the joining conductors (67, 67', 70) do not disturb the functioning of the elementary cells.

3. Device according to claim 1 or claim 2, characterised in that each electrode (69) of the second plurality is constituted by two semi-electrodes (75, 76) electrically separated, each semi-electrode (75 or 76) being connected to a joining conductor (78 or 79) different from the joining conductor connected to the other semi-electrode.

4. Device according to claim 3, characterised in that the means which prevent the disturbances due to the currents circulating in the joining conductors (67, 70, 78, 79) comprise conductor guard electrodes (63, 63', 71, 71', 73, 73') which are disposed subjacent to said joining conductors.

5. Device according to claim 4, characterised in that said guard electrodes (63, 63', 71, 71', 73, 73') are disposed on the first insulating layer (62) and are separated from the first plurality of transparent conductor electrodes (66) by a fourth insulating layer (65).

6. Device according to claim 4, or 5, and according to the arrangement of claim 3, characterised in that the guard electrodes (63, 63') comprise branches (73, 73') which are subjacent to the lines of separation (77) of the semi-electrodes (75, 78).

7. Device according to claim 2 or claim 3, characterised in that the means which prevent disturbances due to the currents circulating in the joining conductors are constituted by areas of insulation distributed in the semi-conductor substrate, and having contours defined by the peripheral contours of the transparent conductor electrodes of the second plurality.

8. Device according to any one of the preceding claims, characterised in that the second insulating layer (23 or 68) only covers the edges of the transparent conductor electrodes (12, 67) of the first plurality.

## Patentansprüche

1. Bildaufnahme- und Ableseeinrichtung für den infraroten Bereich des Spektrums, mit einem Substrat (20) aus halbleitendem Material vom N-Typ oder P-Typ, welches zwei einander gegenüberliegende parallele Hauptflächen aufweist, mit einer elektrisch leitenden Schicht (21), welche eine der beiden einander gegenüberliegenden Hauptflächen bedeckt, mit einer ersten isolierenden Schicht (22), welche die ganze Oberfläche der anderen Hauptfläche bedeckt, mit einem ersten Satz von Elektroden (12), die aus einem transparenten elektrisch leitenden Material hergestellt sind und regelmäßig längs Spalten angeordnet sind, mit einer zweiten isolierenden Schicht (23), welche den ersten Satz lichtdurchlässiger leitender Elektroden (12) überdeckt, mit einem zweiten Satz von Elektroden (11), welche aus einem transparenten elektrisch leitenden Material gefertigt sind und regelmässig längs Zeilen angeordnet sind, und mit einer dritten isolierenden Schicht, welche die transparenten leitenden Elektroden (11) des zweiten Satzes überdeckt, dadurch gekennzeichnet, daß jede Elektrode (12) des ersten Satzes rechteckige Form aufweist und in präziser Weise von einer Elektrode (11) des zweiten Satzes umgeben ist, welche die Form eines rechteckigen Rahmens hat, derart, daß eine Elementarzelle für das Aufnehmen und Ablesen gebildet wird, daß die ringförmig geschlossenen äußeren Elektroden jeder Zeile des zweiten Elektrodensatzes (11) durch einen ersten Verbindungsleiter (Al bis Am oder Il bis Im und Pl bis Pm) untereinander und mit einem Adressierkreis (13 oder 83, 83') verbunden sind und daß die zentralen Elektroden einer jeden Spalte des ersten Elektrodensatzes (12) durch einen zweiten Verbindungsleiter (L1, L2 ... Ln) untereinander und mit einem Verstärker (AL1, AL2, ... ALn) verbunden sind.

2. Einrichtung nach Anspruch 1, dadurch gekennzeichnet, daß die transparenten leitenden Elektroden (66 und 69) derart angeordnet sind, daß die Elementarzellen zum Aufnehmen und Ablesen nach Art eines flächenzentrierten Gitters angeordnet sind, wobei die Elementarzellen Reihen und Spalten bilden, und daß Mittel (63, 63', 71, 71') vorgesehen sind, die verhindern, daß die in den Verbindungsleitern (67, 67', 70) fließenden Ströme das Arbeiten der Elementarzellen stören.

3. Einrichtung nach Anspruch 1 oder 2 dadurch gekennzeichnet, daß eine jede Elektrode (69) des zweiten Satzes durch zwei Halbelektroden (75, 76) gebildet ist, welche elektrisch getrennt sind, und daß jede Halbelektrode (75 oder 76) mit einem Verbindungsleiter (78 oder 79) verbunden ist, welcher sich von demjenigen Verbindungsleiter unterscheidet, der mit der anderen Halbelektrode verbunden ist.

4. Einrichtung nach Anspruch 3, dadurch gekennzeichnet, daß die Mittel, die Störungen verhindern, welche auf die in den Verbindungsleitern (67, 70, 78, 70) fliessenden Ströme zurückzuführen sind, leitende Schutzelektroden (63, 63', 71, 71', 73, 73') umfassen, welche unter den Verbindungsleitern liegend angeordnet sind.

5. Einrichtung nach Anspruch 4, dadurch gekennzeichnet, daß die Schutzelektroden (63, 63', 71, 71', 73, 73') auf der ersten isolierenden Schicht (62) angeordnet sind und von dem ersten Satz transparenter leitender Elektroden (66) durch eine vierte isolierende Schicht (65) getrennt sind.

6. Einrichtung nach Anspruch 4 oder 5 in Verbindung mit Anspruch 3, dadurch gekennzeichnet, daß die Schutzelektroden (63, 63') Zweige (73, 73') aufweisen, welche unter den Trennlinien (77) der Halbelektroden (75, 78) liegen.

7. Einrichtung nach Anspruch 2 oder 3, dadurch gekennzeichnet, daß die Mittel, welche Störungen verhindern, die auf in den Verbindungsleitern fließende Ströme zurückzuführen sind, durch Isolationszonen gebildet sind, welche in das halbleitende Substrat hineindiffundiert sind, und Konturen aufweisen, die durch die Randkonturen der transparenten leitenden Elektroden des zweiten Satzes vorgegeben sind.

8. Einrichtung nach einem der vorstehenden Ansprüche, dadurch gekennzeichnet, daß die zweite isolierende Schicht (22 oder 68) nur die Ränder der transparenten leitenden Elektroden (12, 67) des ersten Satzes überdeckt.

**FIG.1**

**FIG.2**

FIG.3a  $A_1$   0 / -V

FIG.3b  $A_2$   0 / -V

FIG.3c  $A_m$   0 / -V

FIG.3d   0 / -V

FIG.3e   RAZ   RAZ

FIG.3f

FIG.3g

FIG.3h

FIG.3i

0 082 035

FIG.4

0 082 035

3

FIG.5

FIG.6

FIG.7

0 082 035

FIG.8

7

FIG.9a

FIG.9b

FIG.9c

FIG.9d

FIG.9e

0 082 035